Europäisches Patentamt

European Patent Office

Office européen des brevets

(11) Publication number: **0 348 972**
**A2**

## (12) EUROPEAN PATENT APPLICATION

(21) Application number: **89111856.4**

(22) Date of filing: **29.06.89**

(51) Int. Cl.⁴: **H01L 21/58 , H01L 21/60 , H01L 25/065**

(30) Priority: **01.07.88 JP 165551/88**

(43) Date of publication of application:
**03.01.90 Bulletin 90/01**

(84) Designated Contracting States:
**DE FR**

(71) Applicant: **SHARP KABUSHIKI KAISHA**
**22-22 Nagaike-cho Abeno-ku**
**Osaka 545(JP)**

(72) Inventor: **Yamamura, Keiji**
**699-7, Miwa**
**Sakurai-shi Nara-ken(JP)**
Inventor: **Rai, Akiteru**
**4-10-9, Abenosuji Abeno-ku**
**Osaka-shi Osaka-fu(JP)**
Inventor: **Nukii, Takashi**
**39-402, 2-2, Suzaka 5-chome**
**Nara-shi Nara-ken(JP)**

(74) Representative: **Patentanwälte TER MEER -**
**MÜLLER - STEINMEISTER**
**Mauerkircherstrasse 45**
**D-8000 München 80(DE)**

(54) **A semiconductor device and a process for manufacturing thereof.**

(57) A semiconductor device comprising a plurality of semiconductor chips (3,4) and a lead frame (5) incorporated in a single package made of a molding resin (1), in which all or majority of the space between the principal plane (3a) of the first semiconductor chip and the principal plane 4a) of the second semiconductor chip is filled up with a deformation preventive resin (13) capable of withstanding the resin forming heat and resin filling pressure of the molding resin (1) for preventing damages due to deformation of semiconductor chips (3,4) and process for manufacturing the semiconductor device.

*Fig.1*

## A SEMICONDUCTOR DEVICE AND A PROCESS FOR MANUFACTURING THEREOF

### BACKGROUND OF THE INVENTION

#### 1. Field of the Invention

The present invention relates to a semiconductor device, more particularly to its packaging and a process for manufacturing thereof.

#### 2. Description of the Prior Art

Recently as effective means for driving plural semiconductor chips as a system, various methods have been proposed for installing these semiconductor chips into a single ceramic package three-dimensionally, or so-called three-dimensional multi-chip packaging. These techniques are, however, high in the package cost because expensive ceramic packages are used, and this problem has been a bottleneck for obtaining a wide demand.

To solve this problem, for example, three-dimensional multi-chip packages using inexpensive resin molded packages have been already disclosed in the Japanese Laid-Open Patent Application Pub. Nos. 56-62350, 56-62351, and 58-130553 (hereinafter called the first prior art).

In the first prior art, however, the semiconductor chips are fixed to both sides of the chip mounting part of the lead frame, and the electrical connection between semiconductor chips is effected through the lead frame, and therefore multi-terminal connection between semiconductor chips is not realized.

Accordingly, to solve the above problem, a method of connecting two semiconductor chips opposingly, with the principal planes mutually spaced at a specific interval by way of a film carrier was proposed in the Japanese Laid-Open Patent Application Pub. No. 61-248541 (hereinafter called the second prior art).

In the second prior art, however, although multi-terminal connection between semiconductor chips is possible structurally, since the film carrier method is employed, take-out of electrodes is limited to the peripheral region free from elements on the secmiconductor chip. Furthermore, since the space between the principal planes of the confronting semiconductor chips is not filled with resin material or the like, the semiconductor chip may be deformed by the heat and resin filling pressure (usually 50 to 100 kg/cmz) at the time of resin molding, and the element characteristics may be spoiled.

Besides, other three-dimensional structures of semiconductor chips have been also proposed, for example, in the Japanese examined Patent Application Pub. No. 58-45822 (hereinafter called the third prior art) and the Japanese Laid-Open Patent Application Pub. No. 59-88863 (hereinafter called the fourth prior art), and in the third prior art the space between the semiconductor chips is vacant same as in the second prior art, and in the fourth prior art only the surrounding parts between the semiconductor chips are affixed with resin. Therefore, when these semiconductor chips are packaged by using a molding resin, the semiconductor chips are similarly deformed, and the element characteristics deteriorate.

### SUMMARY OF THE INVENTION

It is hence a primary object of the invention to present a semiconductor device small in size and multiple in function, capable of connecting plural semiconductor chips with multiple terminals, and packaging by molding resin without deterioration of element characteristics due to deformation of semiconductor chips, and a process for manufacturing the semiconductor device.

In order to accomplish the above object, a semiconductor device according to the invention, comprises a plurality of semiconductor chips and a lead frame incorporated in a single package made of a molding resin, in which all or majority of a space between a pricnipal plane of the first semiconductor chip and a principal plane of the second semiconductor chip is filled up with a deformation preventive resin for preventing damages due to deformation of semiconductor chips.

In a preferred embodiment, the deformation preventive resin is capable of withstanding resin forming heat and resin filling pressure of a molding resin as the characteristic after curing.

In another preferred embodiment, the deformation preventive resin is capable of flowing smoothly into the space between the semiconductor chips as the characteristic before curing.

In still another embodiment, the deformation preventive resin is of solvent-free type and small in contraction.

In a further preferred embodiment, the deformation preventive resin comprises a filler and one or plural resin selected from the group of epoxy resin, urea resin, melamin resin and phenol resin.

A process for manufacturing semiconductor device in another aspect of the invention, comprises the steps of:
forming on a principal plane of a first semiconductor chip, electrode terminals electrically connected with electrode terminals of a second semiconductor chip and electrode terminals electrically connected with an electrode terminal of the lead frame;

forming a protective film on the other principal plane of the first semiconductor chip;

forming on a principal plane of the second semiconductor chip, electrode terminals electrically connected with the electrode terminals of the first semiconductor chip;

forming a protective film on the other principal plane of the second semiconductor chip;

connecting electrically a metallic film of the electrode terminals of the first semiconductor chip and a metallic film of the electrode terminals of the second semiconductor chip by way of the solder bumps;

filling a space of the principal plane of the first semiconductor chip and the principal plane of the second semiconductor chip with a deformation preventive resin other than a molding resin;

packaging the semiconductor chips by the molding resin; and

cutting and forming the lead frame into a desired shape.

In a preferred embodiment, the deformation prevent resin may contain a gap enough to withstand resin molding heat and resin filling pressure of the molding resin.

In another preferred embodiment, the deformation prevent resin has the coefficient of thermal expansion nearly equal to that of solder material of the solder bumps.

In still another preferred embodiment, a different semiconductor chip is connected on the first semiconductor chip.

In a further preferred embodiment, two or more other semiconductor chips are connected on the first semiconductor chip.

In a yet further preferred embodiment, a third or more semiconductor chip is connected on the second semiconductor chip.

In this means for solving the problems, by filling the space between the principal plane 3a of the first semiconductor chip 3 and the principal plane 4a of the second semiconductor chip 4 with the deformation preventive resin 13 capable of withstanding the resin molding heat and resin filling pressure of the molding resin 1, deterioration of the element characteristics due to deformation of semiconductor chips by heat or pressure at the time of filling with molding resin can be prevented. The plural semiconductor chips can be connected with multiple terminals, thereby realizing a resin molded packaging without causing deterioration of element characteristics due to deformation of semiconductor chips.

As clear from the description herein, according to the invention, deterioration of element characteristics derived from deformation of semiconductor chips due to heat or pressure of filling with molding resin can be prevented by filling the space between the principal plane of the first semiconductor chip and the principal plane of the second semiconductor chip with a deformation preventive resin capable of withstanding the resin molding heat and resin filling pressure of the molding resin, and therefore excellent effects are brought about, such as multi-terminal connection of plural semiconductor chips and resin molded packaging without deterioration of element characteristics due to deformation of semiconductor chips.

## BRIEF DESCRIPTION OF THE DRAWINGS

These and other objects of the invention, as well as the features and advantages thereof, will be better understood and appreciated from the following detailed description taken in conjunction with the drawings, in which:

Fig. 1 is a sectional view of a semiconductor device in a first embodiment of the invention;

Fig. 2 is an enlarged sectional view of the essential parts of the same;

Fig. 3 is an enlarged sectional view of the essential parts of a second embodiment of the invention;

Fig. 4 is an enlarged sectional view of the essential parts of a third embodiment of the invention; and

Fig. 5 is an enlarged sectional view of the essential parts of a fourth embodiment of the invention.

## DETAILED DESCRIPTION OF THE PREFERRED EMBODIMENTS

Referring now to the drawings, some of the preferred embodiments of the invention are described in details below.

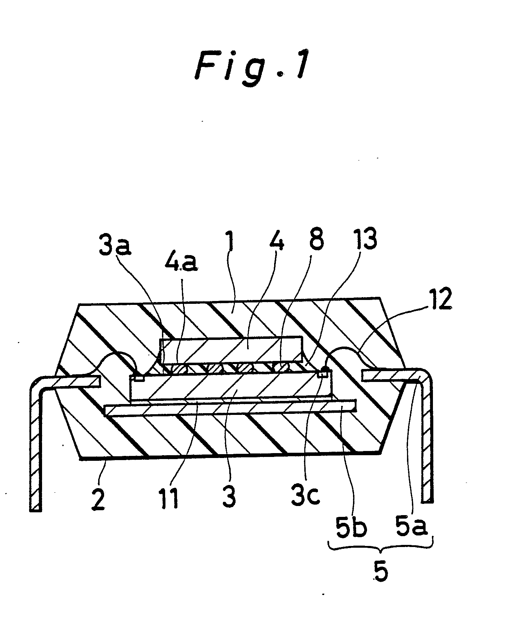

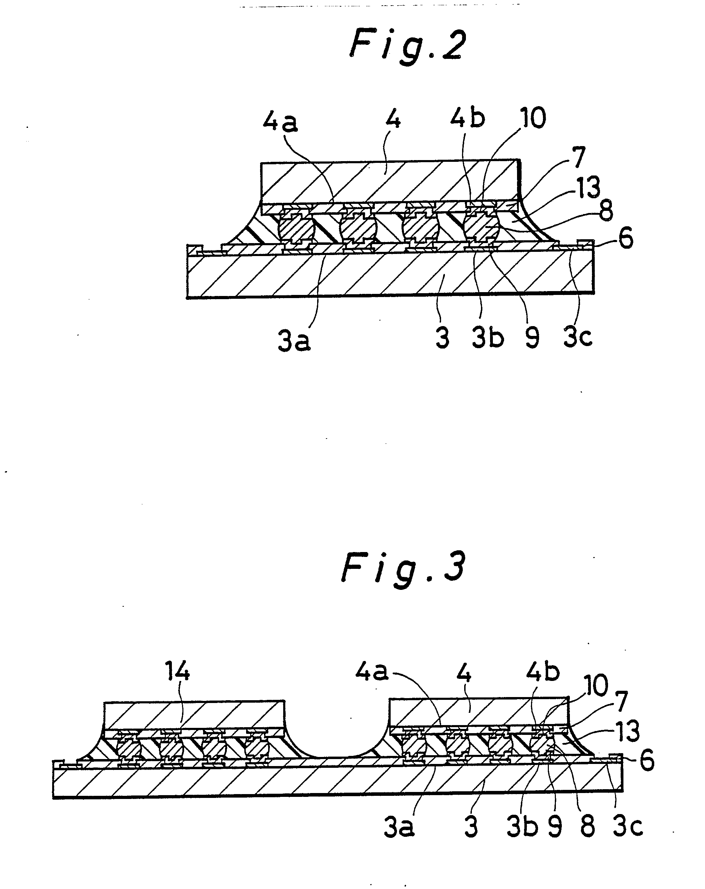

Fig. 1 is a sectional view of a semiconductor device in a first embodiment of the invention, and Fig. 2 is an enlarged sectional view of the essential parts of the same.

As shown in the drawings, the semiconductor device of the invention has a plurality of semiconductor chips 3, 4 and a frame 5 incorporated in a single package 2 made of a molding resin 1, in which the principal plane 3a of the first semiconductor chip 3 and the principal plane 4a of other at least one second semiconductor chip 4 are disposed opposite to each other.

On the principal plane 3a of the first semiconductor chip 3, as shown in Fig. 2, electrode terminals 3b to be electrically connected with electrode terminals 4b of the second semiconductor chip 4, and electrode terminals 3c to be electrically connected with an electrode terminal 5a of the lead frame 5 are formed, and a protective film 6 for example $SiO_2$, SiN and so on is formed on the other principal plane 3a.

On the other hand, on the principal plane 4a of the second semiconductor chip 4, the electrode terminals 4b to be electrically connected with the electrode terminals 3b of the first semiconductor chip 3 are formed, and a protective film 7 for example $SiO_2$, SiN and so on is formed on the other principal plane 4a.

On the surface of the electrode terminal 3b, in order to obtain a favorable electrical connection with solder bumps 8 formed on the electrode terminal 4b of the second semiconductor chip 4, a three-layered metal film 9 of, for example, titanium-tungsten alloy (800Å)/copper (2400Å)/solder (5 μm) is formed.

On the surface of the electrode terminals 4b, in order to form the solder bumps 8, a two-layered metal film 10 of, for example, titanium-tungsten alloy (800Å)/copper (2400Å) is formed, and the solder bumps 8 are formed thereon by vacuum deposition, plating or other method.

As the material for the solder bumps 8, it is necessary to select from those withstanding the temperature when filling with molding resin (170 to 190°C), and in this embodiment an alloy of tin (Sn)/lead (Pb) = 5/95 (melting point 300°C) is used.

The electrode terminals 3b of the first semiconductor chip 3 and the electrode terminals 4b of the second semiconductor chip 4 are connected together by the reflow method by overlaying the electrode terminals 4b on the electrode terminals 3b.

The lead frame 5 is composed of, as shown in Fig. 1, the electrode terminal 5a and a mounting part 5b on which the first semiconductor chip 3 is mounted, and the first semiconductor chip 3 is affixed to the mounting part 5b by means of a die-bonding agent 11.

The electrode terminal 5a and the electrode terminals 3c are electrically connected by means of bonding wire 12 such as aluminum wire and gold wire.

The space between the principal plane 3a of the first semiconductor chip 3 and the principal plane 4a of the second semiconductor chip 4 is preliminarily filled with a deformation preventive resin 13 (liquid thermoset resin) other than the molding resin by means of dispenser or the like, and is later cured in a heating over or the like.

The liquid thermoset resin 13 is required to flow smoothly into the space between the semiconductor chips as the characteristic before curing, and to be of solvent-free type and small in contraction by hardening owing to the necessity of filling the interface completely also after curing. Also as the characteristic after curing, owing to the necessity of minimizing the stress of the connections of solder bumps 8, it is desired that the coefficient of thermal expansion be nearly equal to that of solder material, and it is also necessary to select a material having mechanical properties capable of sufficiently withstanding the resin injection pressure of the molding resin 1 in the subsequent resin forming process. This is particularly important for preventing damages due to deformation of semiconductor chips caused by the stress of injection of molding resin.

As the resin satisfying such conditions, in this embodiment, an epoxy resin containing a filler (e.g. XNR5008-1, manufactured by Nagase Chiba K.K., 1-1-17 Shimmachi, Nishi-ku, Osaka) is used.

The semiconductor chips 3, 4 are packaged by the molding resin 1 using a die, and the lead frame is cut and formed into a desired shape.

Therefore, at the time of manufacture of the semiconductor device of the invention, first, the metallic film 9 of the electrode terminals 3b of the first semiconductor chip 3 and the metallic film 10 of the electrode terminals 4b of the second semiconductor chip 4 are electrically connected with each other by way of the solder bumps 8, and the solder bumps 8 are made of tin (Sn)/lead (Pb) = 5/95 alloy so as to withstand the temperature at the time of filling with molding resin 1.

Next, the space of the principal plane 3a of the first semiconductor chip 3 and the principal plane 4a of the second semiconductor chip 4 is preliminarily filled with the deformation preventive resin 13 other than the molding resin 1. As the characteristic of the deformation preventive resin 13 after curing, in order to minimize the stress at the connections of the solder bumps 8, the material should be selected from those having the coefficient of thermal expansion nearly equal to that of the solder material and mechanical properties capable of sufficiently withstanding the injection pressure of the molding resin 1 in the resin forming process.

In this way, by filling the space between the principal plane 3a of the first semiconductor chip 3 and the principal plane 4a of the second semiconductor chip 4 with the deformation preventive resin 13 capable of withstanding the resin molding heat and resin filling pressure of the molding resin 1, deterioration of the element characteristics derived from the deformation of semiconductor chips due to heat or pressure of filling with molding resin can be prevented, and therefore multi-terminal connection of plural semiconductor chips may be realized, so that the resin molded packaging may be achieved without deterioration of element characteristics due to deformation of the semiconductor chips.

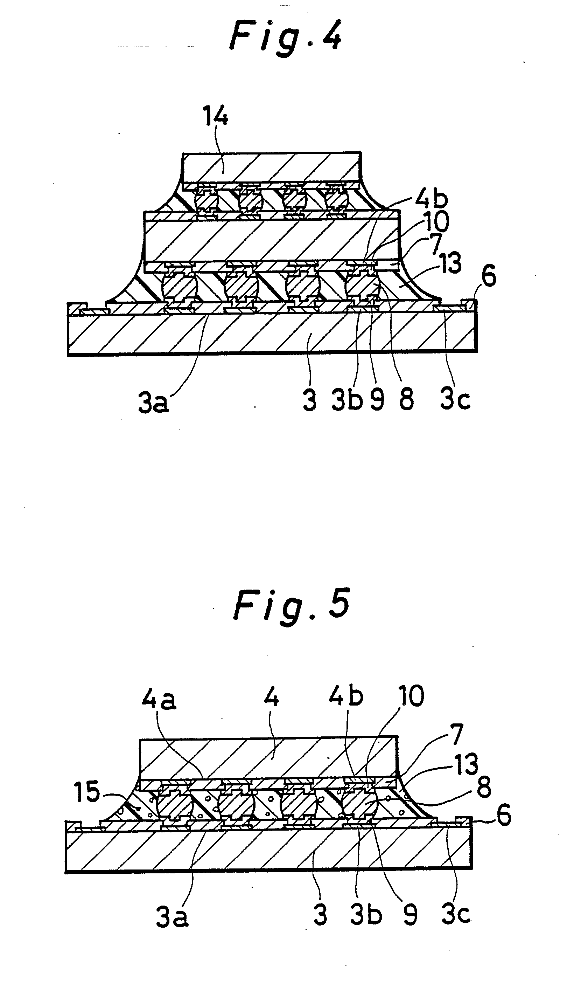

In the foregoing embodiment, a different semiconductor chip was connected on a first semiconductor chip, but the invention is equally valid, needless to say, when two or more semiconductor chips 4, 14 are connected on the first semiconductor chip as shown in a second embodiment in Fig. 3, or when a third semiconductor chip 14 is connected on the second semiconductor chip as shown in a third embodiment in Fig. 4.

Incidentally, as shown in a fourth embodiment in Fig. 5, the curing state of the setting resin of the deformation preventive resin may not always be in the airtight state as in the first embodiment, but also contain a gap 15 enough to withstand the resin molding heat and resin filling pressure of the molding resin.

This invention, meanwhile, is not limited to the foregoing embodiments alone, but may be variously modified or changed within the scope of the invention.

For example, instead of the epoxy resin used as the deformation preventive resin (thermoset resin) in the mentioned embodiment, urea resin, melamin resin, or phenol resin may be used. These thermoset resins are generally excellent in heat resistance and solvent resistance, and are capable of realizing a tough forming by using a filler.

The invention may be embodied in other specific forms without departing from the spirit or essential characteristics thereof. The present embodiments are therefore to be considered in all respects as illustrative and not restrictive, the scope of the invention being indicated by the appended claims rather than by the foregoing description and all changes which come within the meaning and the range of equivalency of the claims are therefore intended to be embraced therein.

## Claims

1. A semiconductor device comprising a plurality of semiconductor chips (3, 4) and a lead frame (5) incorporated in a single package made of a molding resin (1), in which all or majority of a space between a principal plane (3a) of the first semiconductor chip is filled up with a deformation preventive resin (13) for preventing damages due to deformation of semiconductor chips.

2. A semiconductor device as claimed in claim 1 wherein the deformation preventive resin (13) is capable of withstanding resin forming heat and resin filling pressure of a molding resin (1) as the characteristic after curing.

3. A semiconductor device as claimed in claim 2 wherein the deformation preventive resin (13) is capable of flowing smoothly into the space between the semiconductor chips as the characteristic before curing.

4. A semiconductor device as claimed in claim 3 wherein the deformation preventive resin (13) is of solvent-free type and small in contraction.

5. A semiconductor device as claimed in claim 1 wherein the deformation preventive resin (13) comprises a filler and one or plural resin selected from the group of epoxy resin, urea resin, melamin resin and phenol resin.

6. A process for manufacturing semiconductor device comprising the steps of:
forming on a principal plane (3a) of a first semiconductor chip (3), electrode terminals (3b) electrically connected with electrode terminals (4b) of a second semiconductor chip (4) and electrode terminals (3c) electrically connected with an electrode terminal (5a) of the lead frame (5);
forming a protective film (6) on the other principal plane (3a) of the first semiconductor chip (3);
forming on a principal plane (4a) of the second semiconductor chip (4), electrode terminals (4b) electrically connected with the electrode terminals (3b) of the first semiconductor chip (3);
forming a protective film (7) on the other principal plane (4a) of the second semiconductor chip (4);
connecting electrically a metallic film (9) of the electrode terminals (3b) of the first semiconductor chip (3) and a metallic film (10) of the electrode terminals (4b) of the second semiconductor chip (4) by way of the solder bumps (8);
filling a space of the principal plane (3a) of the first semiconductor chip (3) and the principal plane (4a) of the second semiconductor chip (4) with a deformation preventive resin (13) other than a molding resin (1);
packaging the semiconductor chips (3, 4) by the molding resin (1); and
cutting and forming the lead frame (5) into a desired shape.

7. A process as claimed in claim 6 wherein the deformation prevent resin (13) may contain a gap (15) enough to withstand resin molding heat and resin filling pressure of the molding resin (1).

8. A process as claimed in claim 6 wherein the deformation prevent resin has the coefficient of thermal expansion nearly equal to that of solder material of the solder bumps (8).

9. A process as claimed in claim 6 wherein a different semiconductor chip is connected on the first semiconductor chip.

10. A process as claimed in claim 6 wherein two or more other semiconductor chips are connected on the first semiconductor chip.

11. A process as claimed in claim 8 or 9 wherein a third or more semiconductor chip is connected on the second semiconductor chip.

# Fig.1

# Fig.2

# Fig.3

# Fig.4

# Fig.5